# EUROPEAN PATENT SPECIFICATION

(11) **EP 1 406 745 B1**
(45) Date of publication and mention of the grant of the patent: **20.12.2006**
(21) Application number: 02722485.6
(22) Date of filing: 02.05.2002
(51) Int. Cl.: B23K 35/36, C08K 5/05, C08K 5/09, C08K 5/10, H05K 3/34

(54) **SOLDERING FLUX VEHICLE ADDITIVE**
ZUSATZSTOFF FÜR DAS LÖSUNGSMITTEL EINES LÖTFLUSSMITTELS
ADDITIF DE VEHICULE DE FLUX A SOUDER

(30) Priority: 07.06.2001 GB 0113897
(43) Date of publication of application: 14.04.2004
(73) Proprietor: Alpha Fry Limited, Woking, Surrey GU21 5RZ (GB)
(72) Inventor: MALLON, Deborah, London SE16 5GX (GB); PRICE, Andrew, David, Carshalton, Surrey SM5 ITA (GB); SEQUEIRA, Leela, Josephine, Croydon, Surrey CRO 3JY (GB); WILLIAMS, Robert, Derek, Croydon, Surrey (GB)
(74) Representative: Setna, Rohan P.
(86) International application number: PCT/GB2002/002049
(87) International publication number: WO 2002/098601

(56) References cited:
- EP-A- 0 379 290
- RU-C- 2 096 152
- PATENT ABSTRACTS OF JAPAN vol. 013, no. 083 (M-802), 27 February 1989 (1989-02-27) & JP 63 281794 A (NIPPON GENMA:KK), 18 November 1988 (1988-11-18)
- PATENT ABSTRACTS OF JAPAN vol. 015, no. 379 (E-1115), 25 September 1991 (1991-09-25) & JP 03 152803 A (ASAHI CHEM RES LAB LTD), 28 June 1991 (1991-06-28)

## Description

The present invention relates to a soldering flux vehicle which contains an additive to enhance fine pitch stencil printing, and to solder pastes for use in the electronics industry which are prepared using this flux vehicle.

There is a trend in the electronics industry towards the automated manufacture of printed circuit boards (PCBs) and towards the miniaturization of electronic devices with the requirement of finer and finer pitch devices. Solder paste is generally printed onto a substrate through a stainless steel or electroformed stencil. Industry standard stencils for PCB manufacture are generally 0.125mm or 0.150mm in thickness and solder pastes comprising solder powder particles of 25 to 45 microns in diameter are required to print 0.25mm diameter apertures at a 0.5mm pitch.

Solder paste release from a stainless steel or electroformed stencil and subsequent printed pad definition on a PCB is influenced by the chemical nature of the solder paste and, in particular, the soldering flux vehicle. A solder paste has to have a certain amount of "tack" in order that components can be placed in position on the printed solder paste pads accurately and without loss. However, the tackiness of the solder paste which holds a component in position often prevents good printing of the solder paste onto a substrate through a stencil, i.e. good aperture release of the solder paste on printing may be prevented.

Accordingly, there is a requirement for an improved solder flux vehicle and solder paste formulation which has an improved release from a stencil during printing, whilst maintaining the internal tackiness of the solder paste thereby preventing loss of components during the assembly placement of the components onto the PCB.

Accordingly, the present invention provides a solder paste formulation which comprises a solder paste powder and a non-aqueous vehicle, characterized in that the vehicle includes therein at least one lubricant additive which is a branched chain fatty acid containing a total of from 8 to 50 carbon atoms with a minimum of 4 carbon atoms being present in the shorter alkyl chain, or an ester thereof, wherein the branch point is at the second carbon position.

The lubricant additives for use in the present invention are those comprising a branched chain fatty acid, or an ester thereof, wherein the branch point is at the second carbon position. These compounds are generally known as Guerbet acids.

Specific examples of Guerbet acids for use in the present invention are 2-butyloctanoic acid, 2-butyldecanoic acid, 2-hexyldecanoic acid, 2-hexyldodecanoic acid, 2-octyldodecanoic acid, 2-decyltetradecanoic acid or 2-hexadecyleicosanoic acid.

The solder paste compositions of the present invention will generally comprise from 75% to 95% by weight of solder powder, preferably 85% to 90% by weight of solder powder. The solder powder will generally have an average particle size in the range of from 10 to 80 micrometres, preferably 25 to 45 micrometres.

The solder paste is formed from a suitable alloy composition, for example an SnPb (such as Sn37Pb63), SnPbBi, SnBi, SnPbAg; SnAgCu, SnAgCuBi, SnZnBi.

The vehicle which is used in the compositions of the present invention will generally comprise at least one polar organic solvent such as a polyhydric alcohol including ethylene glycol, diethylene glycol, propylene glycol, sorbitol, pentaerythritol and derivatives thereof, butyl diglyme, dibutyl itaconate, di(propylene glycol) butyl ether, 2-ethyl hexyl diglycol, γ-butyrolactone, hexyl carbitol, N-methyl pyrrolidone, N-ethyl pyrrolidone, terpineol or tetraglyme. Tri(propylene glycol) butyl ether is particularly preferred.

The vehicle will generally contain one or more thickeners which enable the rheological characteristics of the vehicle to be modified, as required. Suitable thickeners include polyacrylic acid, hydrogenated castor oil and derivatives thereof, polyamides or resins which may be included in an amount of up to 30wt%.

It may be also be necessary for further components to be added to the vehicle to provide, for instance, fluxing activity for solder reflow. Typical fluxing additives which are known to those skilled in the art may be used. Activators may be included in the solder paste compositions in an amount of up to 7wt%. Other additives may include tackifier(s) and/or antioxidants and/or surfactants at a level of less than 5wt%.

The solder pastes of the present invention contain from 0.1 to 2% by weight of the lubricant additive.

The solder pastes of the present invention possess the advantage that they have an improved release from a stencil during printing and thus are adapted for use in fine pitch stencil printing.

The following non-limiting Examples illustrate the present invention.

### EXAMPLES 1 TO 10

A number of flux gels were produced from the following components given in Table 1 and then mixed with solder powder (Sn62Pb36Ag2 of 25 to 45 micrometres diameter) to give a solder paste containing 10% flux gel and 90% solder powder. Example 4 is not in accordance with the present invention.

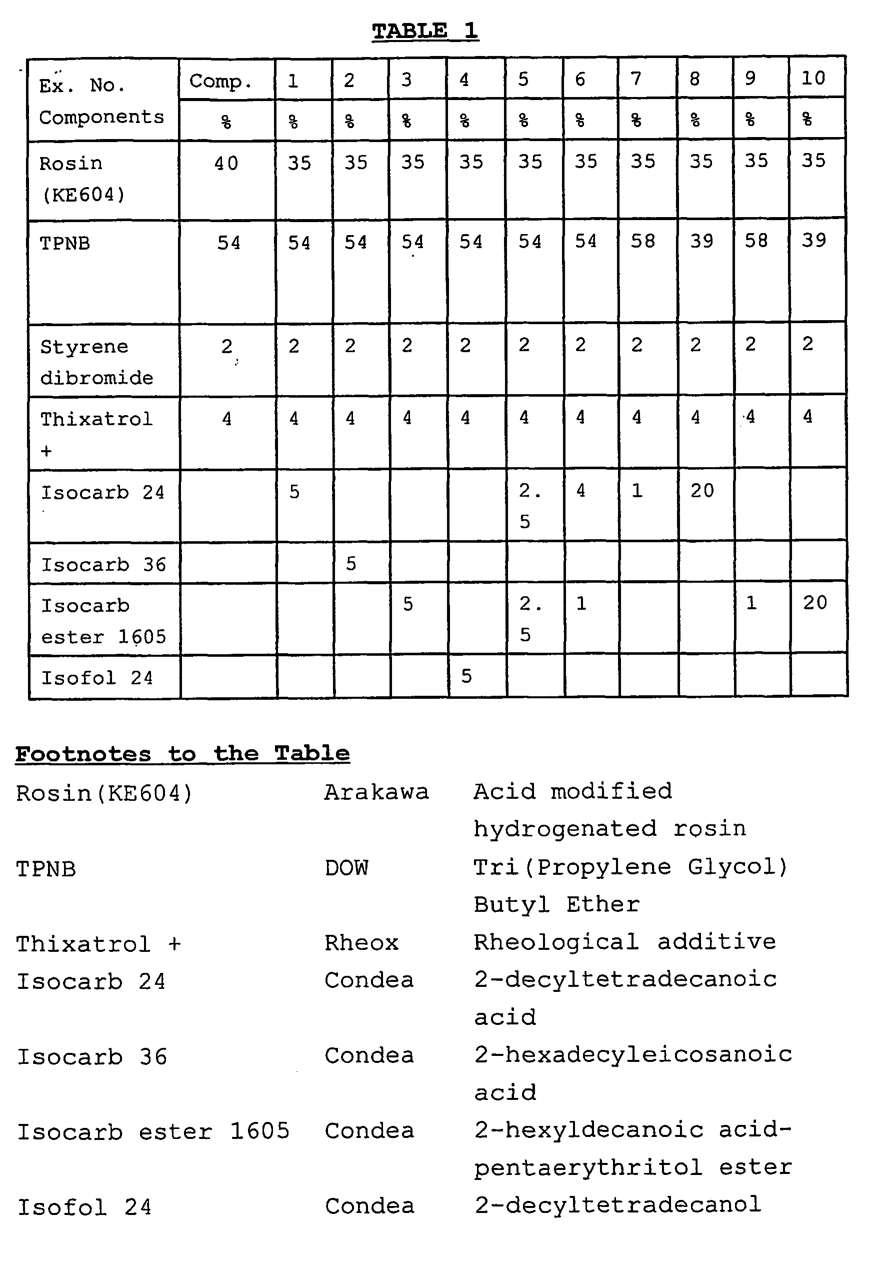

The solder pastes were each printed through a series of 250 micrometre apertures using an electroformed stencil 0.125mm thick and an MPM AP27 printer.

The 1st, 5th and 10th prints were visually examined and compared with a visual standard. In addition the appearance of the first print was recorded at 90 and 45 degrees using the SPIDA (Solder Paste Inspection Data Analyser).

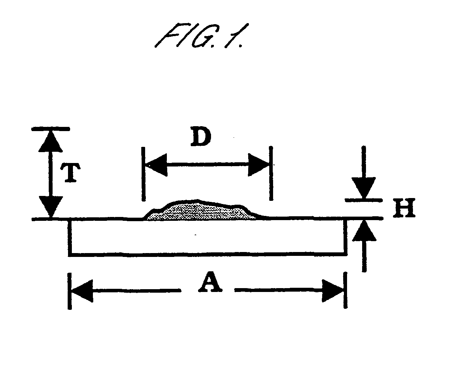

The visual standard which was used to assess the print definition on inspection is described with reference to Figure 1. Referring to Figure 1, T represents the stencil thickness, A the aperture diameter, D the paste diameter and H the paste height. The following scores were given.

| **SCORE** | **DESCRIPTION** | **VALUES** |
|---|---|---|
| 1 | No paste or almost no paste | D<1/2A |
| | | H<1/3T |
| 2 | More than ½ of pad area | D>1/2A |
| | covered but insufficient height | H<2/3T |
| 3 | More than 2/3 pad area | D>2/3A |
| | covered, paste reaches same height | H=T for <1/3A |
| 4 | More than 2/3 pad area | D>2/3A |
| | covered and diameter of top is > 1/3 of aperture | H=T for <1/2A |
| 5 | Perfect deposit, same shape | D = A |
| | as stencil aperture | H = T for > 2/3A |

### Results

The results of the visual inspections are given in Table 2 below.

**TABLE 2**

| **Example** | **Additive (%)** | **Score** |
|---|---|---|
| Comparative | None | 2 |
| 1 | Isocarb 24 . | 3 |
| 2 | Isocarb 36 | 5 |
| 3 | Isocarb ester 1605 | 4 |
| 4 | Isofol 24 | 4 |
| 5 | Isocarb 24 (2.5)/Isocarb | 4 |
| | ester 1605 (2.5) | |
| 6 | Isocarb 24 (4)/Isocarb | 3 |
| | ester 1605 (1) | |
| 7 | Isocarb 24 (1) | 3 |
| 8 | Isocarb 24 (20) | 4 |
| 9 | Isocarb ester 1605 (1) | 3 |
| 10 | Isocarb ester 1605 (20) | 3 |

It can be seen from the results given in Table 2 that the solder pastes made with flux gels containing the lubricant additions showed improved print definition when compared with a paste made with a flux gel containing no lubricant addition. Example 4 is not in accordance with the present invention.

## Claims

1. A solder paste formulation which comprises a solder paste powder and a non-aqueous vehicle, **characterized in that** the vehicle includes therein at least one lubricant additive which is a branched chain fatty acid containing a total of from 8 to 50 carbon atoms with a minimum of 4 carbon atoms being present in the shorter alkyl chain, or an ester thereof, wherein the branch point is at the second carbon position.

2. A solder paste formulation as claimed in claim 1 or claim 2 wherein the additive is 2-butyloctanoic acid, 2-butyldecanoic acid, 2-hexyldecanoic acid, 2-hexyldodecanoic acid, 2-octyldodecanoic acid, 2-decyltetradecanoic acid or 2-hexadecyleicosanoic acid.

3. A solder paste formulation as claimed in claim 1 or claim 2, which comprises from 75% to 95% by weight of a solder powder.

4. A solder paste formulation as claimed in claim 3, wherein the solder powder is an alloy composition of SnPb, SnPbBi, SnBi, SnPbAg, SnAgCu, SnAgCuBi or SnZnBi.

5. A solder paste composition as claimed in any one of the preceding claims, wherein the solder powder has an average particle size in the range of from 10 to 80 micrometres.

6. A solder paste composition as claimed in claim 5, wherein the solder powder has an average particle size in the range of from 25 to 45 micrometres.

7. A solder paste composition as claimed in any one of the preceding claims which comprises from 0.1 to 2% by weight of the lubricant additive.

## Patentansprüche

1. Eine Lötpastenformulierung, die ein Lötpastenpulver und ein nicht wässriges Trägermittel umfasst, die **dadurch gekennzeichnet ist, dass** das Trägermittel darin wenigstens einen Zusatzstoff als Gleitmittel umfasst, der eine verzweigtkettige Fettsäure, die insgesamt 8 bis 50 Kohlenstoffatome enthält, wobei wenigstens 4 Kohlenstoffatome in der kürzeren Alkylkette vorhanden sind, oder ein Ester davon ist, wobei der Verzweigungspunkt die zweite Kohlenstoffposition ist.

2. Eine Lötpastenformulierung, wie sie in Anspruch 1 beansprucht wird, wobei der Zusatzstoff 2-Butyloctansäure, 2-Butyldecansäure, 2-Hexyldecansäure, 2-Hexyldodecansäure, 2-Octyldodecansäure, 2-Decyltetradecansäure oder 2-Hexadecyleicosansäure ist.

3. Eine Lötpastenformulierung, wie sie in Anspruch 1 oder Anspruch 2 beansprucht wird, die 75 % bis 95 Gew.-% eines Lötpulvers umfasst.

4. Eine Lötpastenformulierung, wie sie in Anspruch 3 beansprucht wird, wobei das Lötpulver eine Legierungszusammensetzung aus SnPb, SnPbBi, SnBi, SnPbAg, SnAgCu, SnAgCuBi oder SnZnBi ist.

5. Eine Lötpastenzusammensetzung, wie sie in einem der vorangegangenen Ansprüche beansprucht wird, wobei das Lötpulver eine durchschnittliche Partikelgröße in dem Bereich von 10 bis 80 Mikrometern aufweist.

6. Eine Lötpastenzusammensetzung, wie sie in Anspruch 5 beansprucht wird, wobei das Lötpulver eine durchschnittliche Partikelgröße im Bereich von 25 bis 45 Mikrometern aufweist.

7. Eine Lötpastenzusammensetzung, wie sie in einem der vorangegangenen Ansprüche beansprucht wird, die 0,1 bis 2 Gew.-% des Gleitmittelzusatzstoffes umfasst.

## Revendications

1. Formulation de pâte à braser qui comprend une poudre de pâte à braser et un véhicule non aqueux, **caractérisée en ce que** le véhicule comprend au moins un additif lubrifiant qui est un acide gras à chaîne ramifiée contenant un total de 8 à 50 atomes de carbone avec un minimum de 4 atomes de carbone présents dans la chaîne alkyle plus courte, ou un ester de celui-ci, le point de ramification étant dans la position du deuxième carbone.

2. Formulation de pâte à braser selon la revendication 1, dans laquelle l'additif est un acide 2-butyloctanoïque, un acide 2-butyldécanoïque, un acide 2-hexyldécanoïque, un acide 2-hexyldodécanoïque, un acide 2-octyldodécanoïque, un acide 2-décyltétradécanoïque ou un acide 2-hexadécyleicosanoïque.

3. Formulation de pâte à braser selon la revendication 1 ou la revendication 2, qui comprend de 75 % à 95 % en poids d'une poudre de brasage.

4. Formulation de pâte à braser selon la revendication 3, dans laquelle la poudre de brasage est une composition d'alliage de SnPb, SnPbBi, SnBi, SnPbAg, SnAgCu, SnAgCuBi ou SnZnBi.

5. Composition de pâte à braser selon l'une quelconque des revendications précédentes, dans laquelle la poudre de brasage présente une taille de particule moyenne comprise dans la plage de 10 à 80 micromètres.

6. Composition de pâte à braser selon la revendication 5, dans laquelle la poudre de brasage présente une taille de particule moyenne comprise dans la plage de 25 à 45 micromètres.

7. Composition de pâte à braser selon l'une quelconque des revendications précédentes, qui comprend de 0,1 à 2 % en poids d'additif lubrifiant.
